# EUROPEAN PATENT APPLICATION

(11) **EP 4 439 642 A1**
(43) Date of publication of application: **02.10.2024**
(21) Application number: 24163361.9
(22) Date of filing: 13.03.2024
(51) Int. Cl.: H01L 21/768, H01L 23/48, H01L 23/528, H01L 21/822, H01L 21/8234, H01L 23/485, H01L 27/06, H01L 27/118, H01L 29/423, H01L 29/775

(54) **SEMICONDUCTOR DEVICE**

(30) Priority: 14.03.2023 KR 20230033078
(71) Applicant: Samsung Electronics Co., Ltd., Suwon-si, Gyeonggi-do 16677 (KR)
(72) Inventor: KANG, Sangkoo, 16677 Suwon-si (KR); YOU, Wookyung, 16677 Suwon-si (KR); RYU, Koungmin, 16677 Suwon-si (KR); SEO, Hoonseok, 16677 Suwon-si (KR); LEE, Woojin, 16677 Suwon-si (KR)
(74) Representative: Marks & Clerk LLP

(57) **Abstract**

Provided is a semiconductor device, the semiconductor device, including: a plurality of fin-type active patterns extending in a first direction on a substrate; a gate structure extending in a second direction, and crossing the plurality of fin-type active patterns; a plurality of separation structures extending in the second direction,; source/drain regions disposed on the plurality of fin-type active patterns on both sides of the gate structure; an interlayer insulating layer covering the source/drain regions on the substrate; a contact structure connected to at least one of the source/drain regions; a buried conductive structure electrically connected to the contact structure in the interlayer insulating layer, and having a first width defined by a distance between adjacent separation structures among the plurality of separation structures; and a power transmission structure extending from the second surface toward the first surface of the substrate, and connected to the buried conductive structure.

## Description

### BACKGROUND

### 1. FIELD

Aspects of the present inventive concept relate to a semiconductor device.

### 2. DESCRIPTION OF RELATED ART

In various semiconductor devices such as logic circuits and memories, an active region, such as a source and a drain, is connected to a metal interconnection of a back end of line (BEOL) through a contact structure. There is demand for a method of disposing at least a portion of interconnections (e.g., power lines) of the BEOL on a backside of a substrate and forming a conductive through-structure penetrating the semiconductor substrate in order to connect the portion of the interconnections.

### SUMMARY

An aspect of the present inventive concept is to provide a semiconductor device having a buried conductive structure and a power transmission structure.

According to an aspect of the present inventive concept, provided is a semiconductor device, the semiconductor device including: a substrate having first and second surfaces opposite to each other; a plurality of fin-type active patterns extending in a first direction on the first surface of the substrate; a gate structure extending in a second direction, intersecting the first direction (e.g. wherein the second direction is different to the first direction), and crossing the plurality of fin-type active patterns; a plurality of separation structures arranged in parallel with the gate structure, and extending in the second direction, respectively; source/drain regions disposed on the plurality of fin-type active patterns on both sides of the gate structure; an interlayer insulating layer disposed on the substrate, and covering the source/drain regions; a contact structure penetrating the interlayer insulating layer, and connected to at least one of the source/drain regions; a buried conductive structure electrically connected to the contact structure, and extending in a vertical direction within the interlayer insulating layer between adjacent separation structures among the plurality of separation structures, and having a first width in the first direction defined by a distance between the adjacent separation structures; and a power transmission structure connected to the buried conductive structure, and extending from the second surface toward the first surface of the substrate. The power transmission structure may contact the buried conductive structure.

According to an aspect of the present inventive concept, provided is a semiconductor device, the semiconductor device including: a substrate having first and second surfaces opposite to each other; a plurality of fin-type active patterns extending in a first direction on the first surface of the substrate; a plurality of gate structures extending in a second direction, intersecting the first direction (e.g. wherein the second direction is different to the first direction), and crossing the plurality of fin-type active patterns; a plurality of separation structures arranged in parallel with the plurality of gate structures, and extending in the second direction, respectively; source/drain regions disposed on the plurality of fin-type active patterns on both sides of each of the plurality of gate structures; an interlayer insulating layer disposed on the first surface of the substrate, covering the source/drain regions, and surrounding the plurality of gate structures and the plurality of separation structures; a contact structure penetrating the interlayer insulating layer and connected to at least one of the source/drain regions; a buried conductive structure electrically connected to the contact structure, and extending in a vertical direction within the interlayer insulating layer between two separation structures among the plurality of separation structures; and a power transmission structure extending from the second surface of the substrate toward the first surface of the substrate, and connected to the buried conductive structure, wherein the buried conductive structure includes a first portion having a first width in the first direction defined by a distance between the two separation structures and a second portion disposed on the first portion and having a second width in the first direction, greater than the first width.

According to an aspect of the present inventive concept, provided is a semiconductor device, the semiconductor device including: a substrate having first and second surfaces opposite to each other; a plurality of fin-type active patterns extending in a first direction on the first surface of the substrate; a gate structure extending in a second direction, intersecting the first direction (e.g. wherein the second direction is different to the first direction), and crossing the plurality of fin-type active patterns; a plurality of separation structures arranged in parallel with the gate structure, and extending in the second direction, respectively; source/drain regions disposed on the plurality of fin-type active patterns on both sides of the gate structure; an interlayer insulating layer disposed on the first surface of the substrate, and covering the source/drain regions; a contact structure penetrating the interlayer insulating layer, and connected to at least one of the source/drain regions; a buried conductive structure electrically connected to the contact structure, penetrating the interlayer insulating layer and a device isolation layer between two separation structures among the plurality of separation structures, and extending to a second surface of the substrate; an insulating protective film disposed on the second surface of the substrate, and surrounding a contact region of the buried conductive structure; a backside insulating layer disposed on the insulating protective film; and a power transmission rail disposed in the backside insulating layer, and connected to the contact region of the buried conductive structure, wherein the buried conductive structure includes a portion having a first width in the first direction defined by a distance between the two adjacent separation structures.

At least some of the above and other features of the invention are set out in the claims.

### BRIEF DESCRIPTION OF DRAWINGS

The above and other aspects, features, and advantages of the present inventive concept will be more clearly understood from the following detailed description taken in conjunction with the accompanying drawings, in which:
FIG. 1 is a plan view illustrating a semiconductor device according to an example embodiment of the present inventive concept.
FIG. 2 is a cross-sectional view of the semiconductor device illustrated in FIG. 1 taken along line I-I'.
FIGS. 3A and 3B are cross-sectional views of the semiconductor device illustrated in FIG. 1 taken along lines I1-I1' and II1-II1', respectively.
FIGS. 4A and 4B are cross-sectional views illustrating a semiconductor device according to an example embodiment of the present inventive concept.
FIG. 5 is a plan view illustrating a semiconductor device according to an example embodiment of the present inventive concept.
FIGS. 6A and 6B are cross-sectional views of the semiconductor device illustrated in FIG. 5 taken along lines I2-I2' and II2-II2', respectively.
FIG. 7 is a plan view illustrating a semiconductor device according to an example embodiment of the present inventive concept.
FIG. 8 is a cross-sectional view of the semiconductor device illustrated in FIG. 7 taken along line I-I'.
FIGS. 9A and 9B are cross-sectional views of the semiconductor device illustrated in FIG. 7 taken along lines 13-13' and II3-II3', respectively.
FIG. 10 is a plan view illustrating a semiconductor device according to an example embodiment of the present inventive concept.
FIGS. 11A and 11B are cross-sectional views of the semiconductor device illustrated in FIG. 10 taken along lines I4-I4' and II4-II4', respectively.

### DETAILED DESCRIPTION

Hereinafter, various embodiments of the present inventive concept will be described in detail with reference to the accompanying drawings.

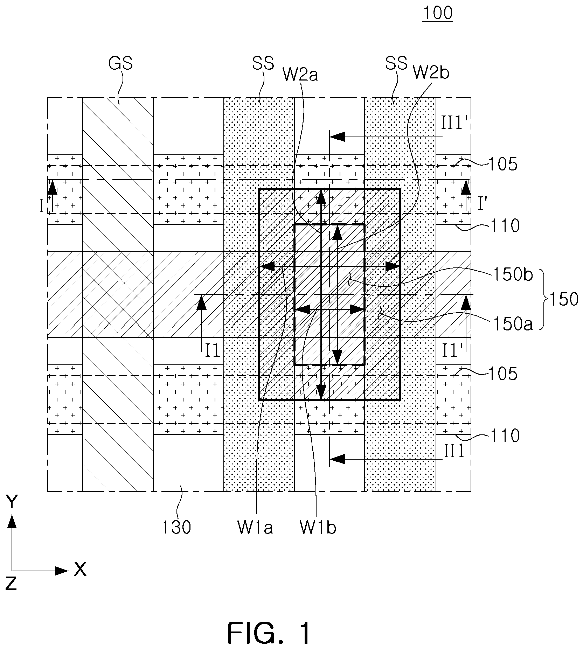

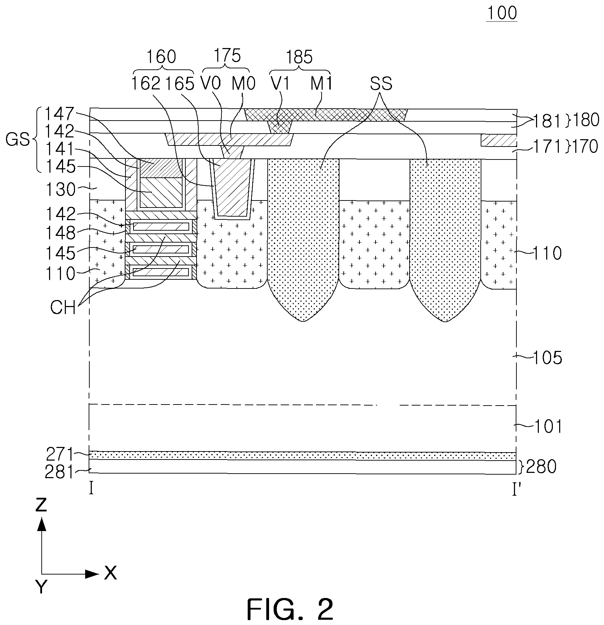

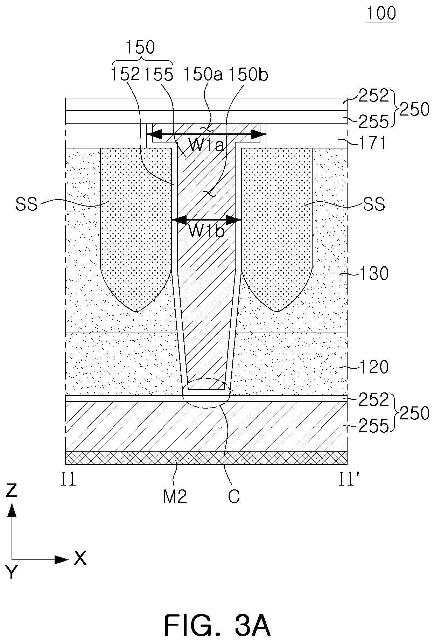

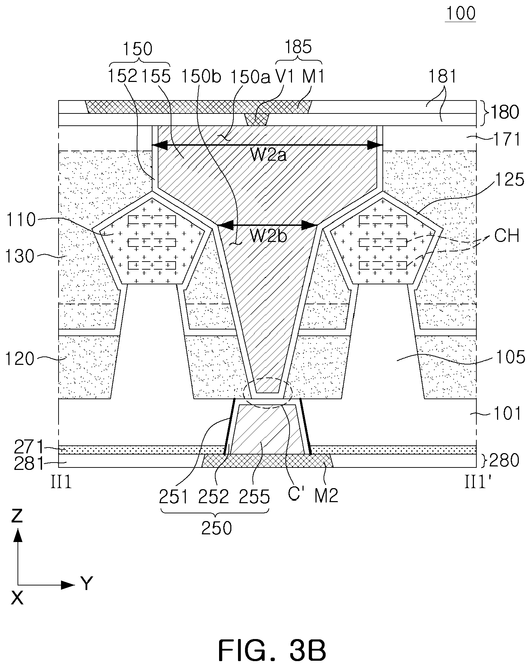

FIG. 1 is a plan view illustrating a semiconductor device according to an example embodiment of the present inventive concept, and FIG. 2 is a cross-sectional view of the semiconductor device illustrate in FIG. 1 taken along line I-I'. FIGS. 3A and 3B are cross-sectional views of the semiconductor device illustrated in FIG. 1 taken along lines I1-I1' and II1-II1', respectively.

Referring to FIGS. 1, 2, 3A, and 3B, a semiconductor device 100 according to the present embodiment may include a substrate 101 having first and second surfaces opposite to each other, first and second fin-type active pattern 105 extending in a first direction (e.g., X-direction) on the first surface (or active region) of the substrate 101, a gate structure GS extending in a second direction intersecting the first direction, and crossing the fin-type active pattern 105, first and second separation structures SS extending in the second direction to be parallel with the gate structure GS, respectively, and a source/drain region 110 disposed on the fin-type active pattern 105 on both sides of the gate structure GS in the first direction. The second direction intersects the first direction in the sense that the first and second directions are different (e.g., wherein the first direction is the X-direction and the second direction is the Y-direction).

Here, the first and second separation structures SS may be disposed adjacently to each other, and may be arranged at a constant pitch in a first direction (e.g., an X-direction) with respect to the gate structure GS.

As illustrated in, for example FIG. 3B. the semiconductor device 100 according to the present embodiment includes a buried conductive structure 150 extending through an interlayer insulating layer 130 and a device isolation layer 120 to the first surface of the substrate 101, and a power transmission structure 250 penetrating the substrate 101 and connected to the buried conductive structure 150. In the present embodiment, the buried conductive structure 150 may be electrically connected to the source/drain region 110 through a first interconnection structure 180, and the power transmission structure 250 may be configured to receive power from a back side of the substrate 101, that is, the second surface, and transmit the power to a device region (e.g., a source/drain region 110) through the buried conductive structure 150.

The buried conductive structure 150 employed in the present embodiment may have a structure obtained by being self-aligned using adjacent first and second separation structures SS and adjacent source/drain regions 110 located therebetween. This will be described in detail with reference to FIGS. 3A and 3B.

The substrate 101 may include, for example, a semiconductor such as Si or Ge, or a compound semiconductor such as SiGe, SiC, GaAs, InAs, or InP. In another example, the substrate 101 may have a silicon on insulator (SOI) structure. An active region having a well doped with impurities may be disposed on a first surface of the substrate 101, and a fin-type active pattern 105 may be provided as a structure extending in the first direction on an active region (e.g., the X-direction). In the present embodiment, although not limited thereto, the active region and the active pattern may be an N-type region for a P-MOS transistor or a P-type region for an N-MOS transistor.

The device isolation layer 120 may be provided to define an active region including a fin-type active pattern 105. For example, the device isolation layer 120 may include a silicon oxide or a silicon oxide-based insulating material. The device isolation layer 120 may be divided into a first device separation region defining an active region in which a fin-type active pattern 105 is formed, and a second device separation region defining the fin-type active pattern 105. The first device separation region may have a deeper bottom surface than the second device separation region. For example, the first device separation region may also be referred to as deep trench isolation (DTI), and the second device separation region may also be referred to as shallow trench isolation (STI).

Referring to FIGS. 1 and 2, the fin-type active pattern 105 extends in the first direction (e.g., X-direction) on the first surface of the substrate 101 and has a structure protruding from the upper surface of the active region. On the fin-type active pattern 105, a plurality of channel layers CH may be disposed to be spaced apart from each other in a third direction (e.g., Z-direction) perpendicular to the first surface of the substrate 101. The fin-type active pattern 105 and the plurality of channel layers CH may be provided as a multichannel layer of a transistor. In the present embodiment, the plurality of channel layers CH is exemplified as three, but the number thereof is not particularly limited. For example, the plurality of channel layers CH may include at least one semiconductor of silicon (Si), silicon germanium (SiGe), and germanium (Ge). In some embodiments, the plurality of channel layers CH may include the same semiconductor as the substrate 101.

As illustrated in FIG. 1, the semiconductor device 100 according to the present embodiment may include a line-shaped gate structure GS extending in the second direction (e.g., the Y-direction). The gate structure GS may extend to cross one region of the fin-type active pattern 105.

As illustrated in FIG. 2, the gate structure GS employed in the present embodiment includes gate spacers 141, a gate insulating film 142, a gate electrode 145, and a gate capping layer 147. The gate capping layer 147 may be disposed on the gate electrode 145. The gate insulating film 142 may be disposed between the gate spacers 141 and contact side surfaces of the gate electrode 145 and the gate capping layer 147, and may contact a bottom surface of the gate electrode 145. For example, the gate spacers 141 may include an insulating material such as SiOCN, SiON, SiCN, or SiN. The gate insulating film 142 may be formed of, for example, a silicon oxide layer, a high dielectric film, or a combination thereof. The high dielectric film may include a material having a higher dielectric constant (e.g., about 10 to 25) than the silicon oxide film. For example, the high dielectric layer may include hafnium oxide, hafnium oxynitride, hafnium silicon oxide, lanthanum oxide, lanthanum aluminum oxide, and a material selected from a combination thereof, but an example embodiment thereof is not limited thereto. The gate electrode 145 may include a conductive material, for example, a metal nitride such as titanium nitride (TiN), tantalum nitride (TaN), or tungsten nitride (WN), and/or aluminum (Al), tungsten (W), molybdenum (Mo), or the like, or a semiconductor material such as doped polysilicon. In some embodiments, the gate electrode 145 may be a multilayer including two or more films. In addition, the gate capping layer 147 may include, for example, silicon nitride, silicon oxynitride, silicon carbonitride, or silicon oxycarbonitride.

The source/drain regions 110 may be disposed on a region of the fin-type active pattern 105 positioned on both sides of the gate structure GS. The source/drain regions 110 may be respectively connected to both ends of the plurality of channel layers CH in the first direction (e.g., the X-direction). The gate electrode 145 may extend in the second direction (e.g., the Y-direction) to cross the fin-type active pattern 105 while surrounding the plurality of channel layers CH. The gate electrode 145 may be interposed not only in a space between the gate spacers 141 but also between the plurality of channel layers CH.

In the present embodiment, the gate structure GS may include internal spacers 148 provided between each of the source/drain regions 110 and the gate electrode 145. The internal spacers 148 are provided on both sides of the gate electrode 145 in a first direction (e.g., an X-direction) and are interposed between the plurality of channel layers CH. The plurality of channel layers CH may be respectively connected to the source/drain regions 110 on both sides thereof. The gate electrode 145 is interposed between the plurality of channel layers CH and may be electrically insulated from the source/drain regions 110 on both sides thereof by the internal spacers 148. The gate insulating film 142 may be respectively interposed between the gate electrode 145 and the plurality of channel layers CH, and may also extend between the gate electrode 145 and the internal spacers 148. As described above, the semiconductor device 100 according to the present embodiment may comprise a gate-all-around type field effect transistor.

The source/drain region 110 may include an epitaxial pattern selectively epitaxially grown (SEG) using a recessed surface of the fin-type active pattern 105 (including side surfaces of the plurality of channel layers CH) on both sides of the gate structure GS as a seed. This source/drain region 110 is also referred to as a raised source/drain (RSD). For example, the source/drain regions 110 may be Si, SiGe, or Ge, and may have either N-type or P-type conductivity. When a P-type source/drain region 110 is formed, the region may be regrown with SiGe, and may be doped with a P-type impurity, for example, boron (B), indium (In), gallium (Ga), boron trifluoride (BF₃), or the like. When silicon (Si) is formed in an N-type source/drain region 110, the N-type source/drain region 110 may be doped with a N-type impurity, for example, phosphorus (P), nitrogen (N), arsenic (As), antimony (Sb), or the like. The source/drain region 110 can have different shapes in a crystallographically stable plane during a growth process. For example, as illustrated in FIG. 2, the source/drain region 110 may have a pentagonal cross-section (in the case of a P-type), but may have a hexagonal cross-section or a polygonal cross-section with gentle angles (in the case of N-type). An etch stop film 125 may be formed on the source/drain regions 110. As illustrated in FIG. 3B, the etch stop film 125 may extend along a device isolation layer 120.

The semiconductor device 100 according to the present embodiment may include an interlayer insulating layer 130 disposed on the device isolation layer 120. The interlayer insulating layer 130 may be disposed around the gate structure GS while partially covering the source/drain region. For example, the interlayer insulating layer 130 may be formed of Flowable Oxide (FOX), Tonen SilaZen (TOSZ), Undoped Silica Glass (USG), Borosilica Glass (BSG), PhosphoSilaca Glass (PSG), BoroPhosphoSilica Glass (BPSG), Plasma Enhanced Tetra Ethyl Ortho Silicate (PETEOS), Fluoride Silicate Glass (FSG), High Density Plasma (HDP) oxide, Plasma Enhanced Oxide (PEOX), Flowable CVD (FCVD) oxide, or a combination thereof. The interlayer insulating layer 130 may be formed using a chemical vapor deposition (CVD) process, a flowable-CVD process, or a spin coating process.

A contact structure 160 may penetrate the interlayer insulating layer 130, and be connected to the source/drain region 110. The contact structure 160 may connect the source/drain region 110 to the intermediate interconnection layer 175 and the first interconnection layer 185. The contact structure 160 may include a conductive barrier 162 and a contact plug 165. For example, the contact plug 165 may include Cu, Co, Mo, Ru, W, or an alloy thereof. In addition, the conductive barrier 162 may include Ta, TaN, Mn, MnN, WN, Ti, TiN, or a combination thereof.

The semiconductor device 100 according to the present embodiment may include first and second separation structures SS arranged adjacently to each other.

The first and second separation structures SS may be spaced apart by a distance which is equal to a spacing between the gate structure GS and an adjacent one of the first and second separation structures SS. In addition, the first and second separation structures SS may be disposed on the substrate 101 to cross the active pattern 105 and extend in a second direction (Y-direction). The first and second separation structures SS may extend in a third direction (Z-direction), perpendicular to the upper surface of the substrate 101, and may extend into the active pattern 105 between adjacent source/drain regions 110. Although the first and second separation structures SS are not directly illustrated in the cross-section of FIG. 3B, a level of the first and second separation structures SS is indicated by dotted lines

The first and second separation structures SS are regions that do not operate as devices, and may separate a plurality of transistors each including the gate structure GS and the source/drain regions 105 from each other.

The first and second separation structures SS may be positioned on a level higher than at least an upper surface of the gate electrode 145. In the present embodiment (particularly, in a region around the interlayer insulating layer 130 between the source/drain region 105), the upper surfaces of the first and second separation structures SS may have substantially the same level as the upper surface of the gate structure GS. Lower surfaces of the first and second separation structures SS may be on a level lower than lower ends of the source/drain regions 110. In some embodiments, the lower surfaces of the first and second separation structures SS may be on a level higher than a lower end of the active pattern 105.

The first and second separation structures SS may include an insulating material, and may include, for example, at least one of SiN, SiCN, SiOC, SiON, and SiOCN. The first and second separation structures SS may include a material different from that of the device isolation layer 120 and the interlayer insulating layer 130.

The power transmission system employed in the present embodiment includes the buried conductive structure 150 penetrating the interlayer insulating layer 130 and the device isolation layer 120, and the power transmission structure 250 penetrating the substrate 101 and connected to the buried conductive structure 150. The buried conductive structure 150 may be buried in the interlayer insulating layer 130 and the device isolation layer 120 and may be electrically connected to the source/drain region 110. In the present embodiment, the contact structure 160 connected to the source/drain region 110 may be configured to electrically connect the buried conductive structure 150 through a first interconnection structure 180 and an intermediate interconnection structure 170, which comprises the intermediate interconnection layer 175 an intermediate insulating layer 171 on which the intermediate interconnection layer 175 is formed. In the present embodiment, the first interconnection structure 180 may include a plurality (e.g., two) of first insulating layers 181 and a first interconnection layer 185 formed on the first insulating layers 181. The first interconnection layer 185 may include a metal line M1 and a metal via V1. For example, the first interconnection layer 185 may be formed through a dual damascene process. Similarly thereto, the intermediate interconnection layer 175 may include a metal line M0 and a metal via V0.

In the present embodiment, as described above, the buried conductive structure 150 may be a structure obtained by using adjacent first and second separation structures SS and adjacent source/drain regions 110 located therebetween.

As illustrated in FIGS. 3A and 3B, the buried conductive structure 150 may be divided into a lower region 150b extending toward the substrate 101 between the first and second separation structures SS, and an upper region 150a located on the lower region 150b, and located on a level higher than the upper surfaces of the first and second separation structures SS.

The upper region 150a of the buried conductive structure 150 may be formed in the intermediate insulating layer 171 positioned on the first and second separation structures SS. The lower region 150b of the buried conductive structure 150 may be self-aligned by the adjacent first and second separation structures SS and the adjacent source/drain regions 110.

Specifically, a first width W1b of the lower region 150b in the first direction (e.g., the X-direction) may be defined by a distance between adjacent separation structures SS (see FIG. 3A). Similarly thereto, a second width W2b of the lower region 150b in the second direction (e.g., the Y-direction) may be defined by a distance between adjacent source/drain regions 110 (see FIG. 3B).

In particular, since the first and second separation structures SS include a material (e.g., silicon nitride) different from the device isolation layer 120 and the interlayer insulating layer 130, and have a relatively deep depth (e.g., a level lower than the upper surface of the active pattern), the lower region 150b may be stably aligned to a relatively large depth by the first and second separation structures SS.

The upper region 150a of the buried conductive structure 150 may be a region defined by a mask formed by a photolithography process. Since a process margin is proportional to widths of the first and second isolation structures SS and widths of the source/drain regions 110, the upper region 150a of the buried conductive structure 150 may have a slightly wider width than each width of the lower region 150b.

Specifically, a first width W1a of the upper region 150a in the first direction (e.g., the X-direction) may be greater than a first width W1b of the lower region 150b (see FIG. 3A). Similarly thereto, a second width W2a of the upper region 150a in the second direction (e.g., the Y-direction) may be greater than a second width W2b of the lower region 150b (see FIG. 3B).

As described above, since the buried conductive structure 150 employed in the present embodiment (in particular, the lower region 150b) may be self-aligned using an existing structure (e.g., the separation structure SS or the source/drain region 110), despite high integration of the semiconductor device 100, the difficulty of the photolithography (mask) process and the etching process may be reduced.

In the present embodiment, the buried conductive structure 150 may extend to a first surface of the substrate 101. The power transmission structure 250 may contact the buried conductive structure 150 on the first surface of the substrate 101.

In the present embodiment, the buried conductive structure 150 may include a pillar-shaped via structure, and the power transmission structure 250 may have a rail structure extending in a first direction (e.g., an X-direction). The power transmission structure 250 may extend from the second surface of the substrate 101 to the first surface. The power transmission structure 250 may have a contact region C in contact with a bottom surface of the buried conductive structure 150 on the first surface of the substrate 101.

The buried conductive structure 150 may include a first conductive material 155 and a first conductive barrier 152 surrounding a side surface of the first conductive material 155. The power transmission structure 250 may include a second conductive material 255 extending from the second surface to the first surface of the substrate 101, a second conductive barrier 252 disposed on a side surface and an upper surface (a contact surface) of the second conductive material 255, and a second insulating liner 251 disposed between the second conductive barrier 252 and the substrate 101.

For example, the first and second conductive materials 155 and 255 may include Cu, Co, Mo, Ru, W, or an alloy thereof. In some embodiments, the first and second conductive materials 125 and 255 may include different conductive materials. For example, the first and second conductive materials 155 and 255 may include W or Mo, and the second conductive material 255 may include Cu.

For example, the first and second conductive barriers 152 and 252 may include Ta, TaN, Mn, MnN, WN, Ti, TiN, or a combination thereof. In some embodiments, the first conductive barrier 152 and the second conductive barrier 252 may include different conductive materials. For example, the first conductive barrier 122 may include TiN. The second conductive barrier 252 may include TaN or Co/TaN. For example, the second insulating liner 251 may include SiO₂, SiN, SiCN, SiC, SiCOH, SiON, Al₂O₃, AlN, or a combination thereof.

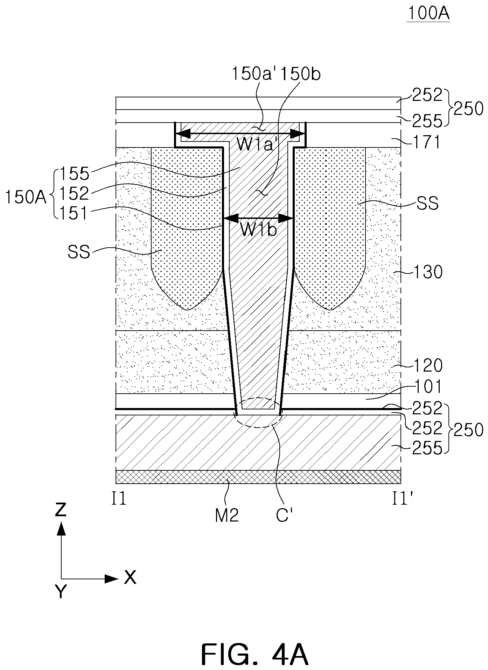

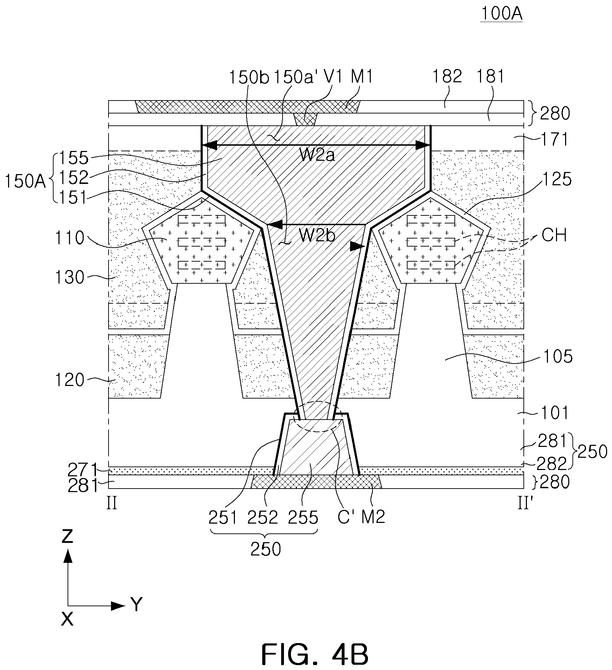

FIGS. 4A and 4B are cross-sectional views illustrating a semiconductor device according to an example embodiment of the present inventive concept.

Referring to FIGS. 4A and 4B, it can be understood that the semiconductor device 100A according to the present embodiment has a structure similar to the semiconductor device 100 illustrated in FIGS. 1 to 3A and 3B, except that the buried conductive structure 150A has an asymmetric structure in at least one cross-section and the buried conductive structure 150A and the power transmission structure 250 are in contact within the substrate 101. In addition, components of the present embodiment may be understood with reference to descriptions of the same or similar components of the semiconductor device 100 illustrated in FIGS. 1 to 3A and 3B unless otherwise stated.

In this embodiment, similar to the previous embodiment, the buried conductive structure 150A is a structure obtained by using adjacent first and second separation structures SS and adjacent source/drain regions 110 located therebetween.

A lower region 150b may have a width W1b defined by the adjacent separation structures SS in the first direction (e.g., X-direction), and an upper region 150a may have a width W1a' greater than the width W1b of the lower region 150b in the first direction (e.g., X-direction).

The buried conductive structure 150A employed in the present embodiment may have an asymmetric structure in a cross-section (a cross-section in the X-direction) illustrated in FIG. 4A. An upper region 150a' of the buried conductive structure 150A may be positioned asymmetrically left and right with respect to a center line of the lower region 150b. Even when a mask forming an opening for the buried conductive structure 150A is misaligned, the lower region may be self-aligned by the first and second separation structures SS and positioned to exactly overlap the power transmission structure 250.

Referring to FIG. 4B, although the buried conductive structure 150A is illustrated as having a symmetrical structure, similarly to the asymmetrical structure of FIG. 4A, an upper region may be misaligned, and even in this case, it may be self-aligned by the adjacent source/drain regions 110.

As described above, since in the buried conductive structure 150A employed in the present embodiment, the buried conductive structure 150A (in particular, the lower region 150b) may be self-aligned using the separation structure SS, the difficulty of a photolithography (mask) process and an etching process may be reduced despite high integration of the semiconductor device 100A.

In addition, in the present embodiment, unlike the previous embodiment, the buried conductive structure 150A may pass through the first surface of the substrate 101 and extend into the substrate 101. The power transmission structure 250 may extend within the substrate 110 and contact a bottom surface of the buried conductive structure 150A. The buried conductive structure 150A employed in the present embodiment may include a first conductive material 155, a first conductive barrier 152 surrounding a side surface and a bottom surface of the first conductive material 155, and a first insulating liner 151 surrounding a portion of the first conductive barrier 152 located on a side surface of the first conductive material 155. The first insulating liner 151 may prevent an electrical connection between the buried conductive structure 150A and the substrate 101.

In the present embodiment, as illustrated in FIG. 4B, an upper surface of the power transmission structure 250 has a contact region C' in contact with the bottom surface of the buried conductive structure 150A and a peripheral region located around the contact region C'. In order to prevent unwanted contact with the substrate 101, a second insulating liner 251 of the power transmission structure 250 may extend to a peripheral region of the upper surface of the power transmission structure 250.

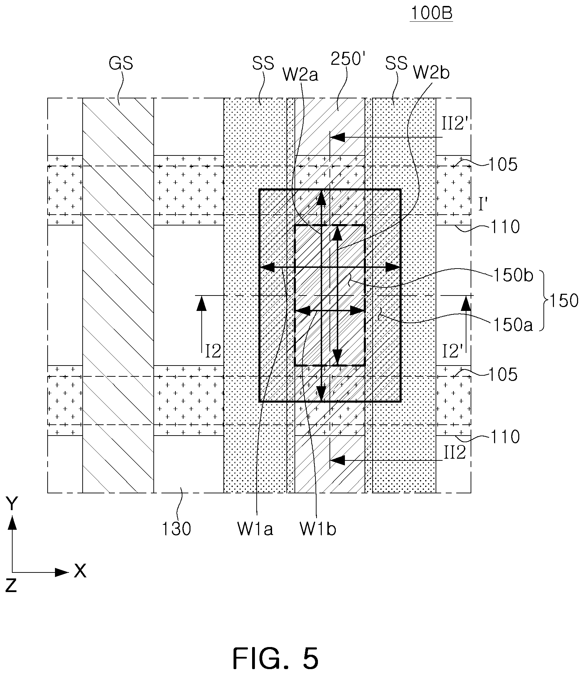

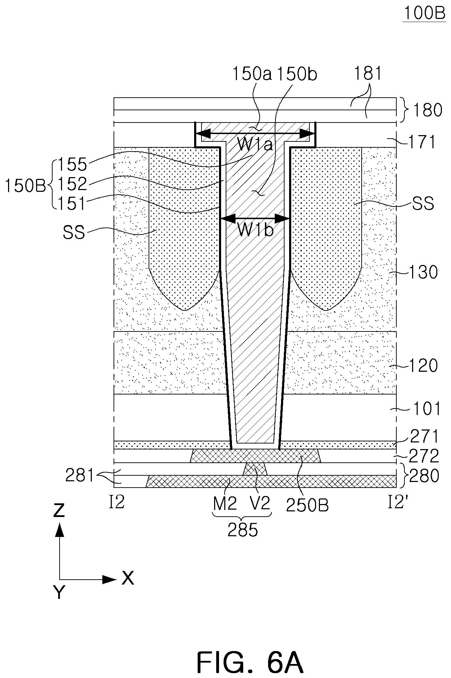

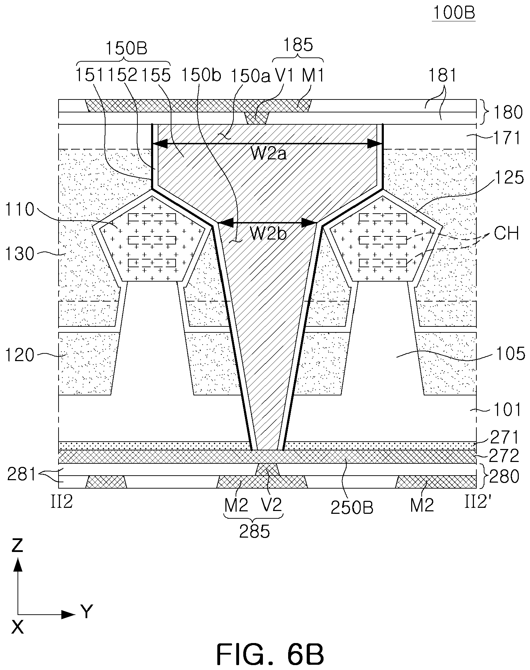

FIG. 5 is a plan view illustrating a semiconductor device according to an example embodiment, and FIGS. 6A and 6B are cross-sectional views of the semiconductor device illustrated in FIG. 5 taken along lines I2-I2' and II2-II2', respectively.

Referring to FIGS. 5, 6A, and 6B, it can be understood that a semiconductor device 100B according to the present embodiment has a structure similar to that of the semiconductor device 100 illustrated in FIGS. 1 to 3A and 3B, except that a power transmission structure 250B extends in the other direction (Y-direction) on the second surface of the substrate 101 and the buried conductive structure 150B penetrates the substrate 101 and contacts the power transmission structure 250B. In addition, components of the present embodiment may be understood with reference to descriptions of the same or similar components of the semiconductor device 100 illustrated in FIGS. 1 to 3A and 3B unless otherwise stated.

The power transmission structure 250B employed in the present embodiment may be disposed on a second surface of the substrate 101, and may extend in the second direction (Y-direction), unlike the previous embodiment. The buried conductive structure 150B may penetrate the substrate 101 and contact the power transmission structure 250B.

As illustrated in FIGS. 6A and 6B, an insulating protective film 271 may be disposed on a second surface of the substrate 101. The insulating protective film 271 may be provided to surround a contact region of the buried conductive structure 150B protruding from the second surface of the substrate 101. A backside insulating layer 272 may be disposed on the insulating protective film 271. The insulating protective film 271 and the back insulating layer 272 may include other insulating materials. For example, the insulating protective film 271 may include AlN or SiN, and the back insulating layer 272 may include SiO₂. In the present embodiment, a power transmission structure 250B may be formed on the back insulating layer 272 using a damascene process. Although not illustrated, the power transmission structure 250B may include a conductive material and a conductive barrier disposed on a side surface and a bottom surface of the conductive material. For example, the conductive material may include Cu, Co, Mo, Ru, W, or an alloy thereof, and the conductive barrier may include Ta, TaN, Mn, MnN, WN, Ti, TiN, or a combination thereof.

In addition, a second interconnection structure 280 may be formed on the back insulating layer 272, similarly to the first interconnection structure 180. The second interconnection structure 280 may include a plurality (e.g., two) of second insulating layers 281 and a second interconnection layer 285 formed on the second insulating layer 281 and connected to the power transmission structure 250B. The second interconnection layer 285 may include a metal line M2 and a metal via V2. For example, the second interconnection layer 285 may be formed through a dual damascene process.

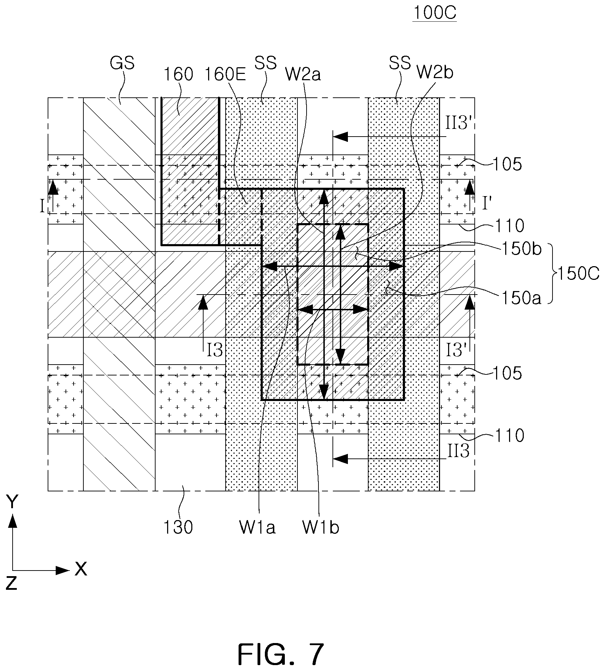

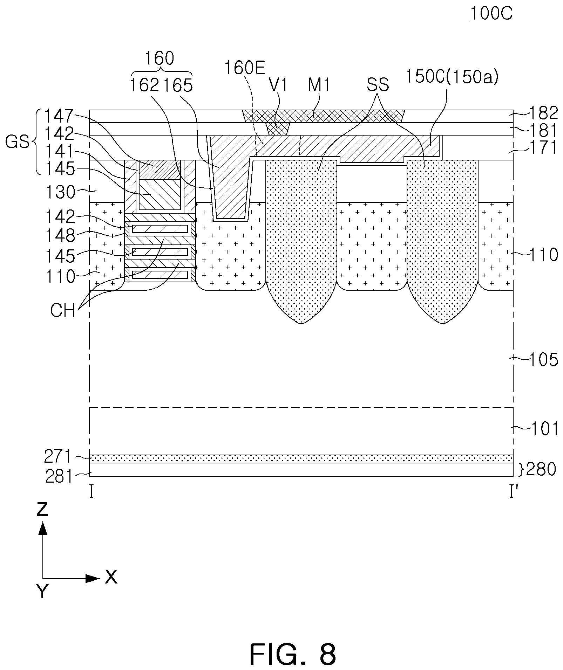

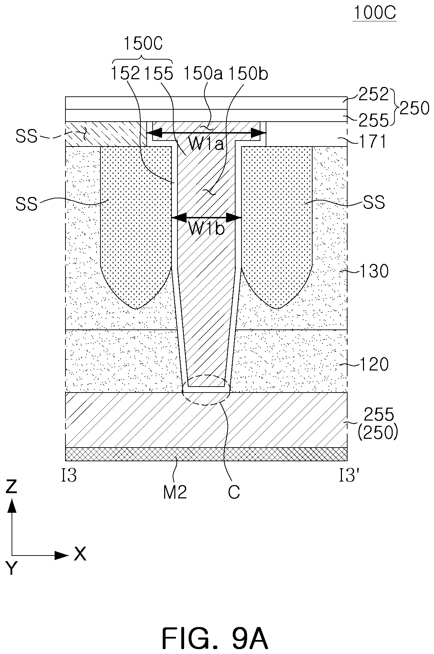

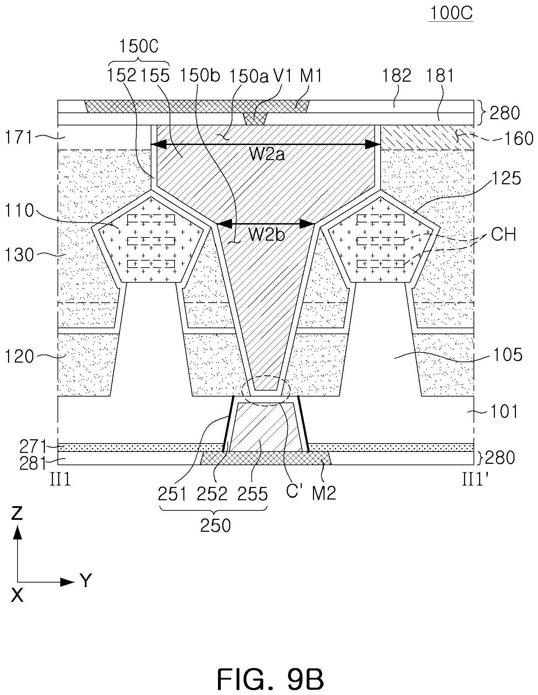

FIG. 7 is a plan view illustrating a semiconductor device according to an example embodiment, FIG. 8 is a cross-sectional view of the semiconductor device illustrated in FIG. 7 taken along line I-I', and FIGS. 9A and 9B are cross-sectional views of the semiconductor device illustrated in FIG. 7 taken along lines 13-13' and II3-II3', respectively.

Referring to FIGS. 7 to 9A and 9B, it can be understood that the semiconductor device 100C according to the present embodiment has a structure similar to the semiconductor device 100 illustrated in FIGS. 1 to 3A and 3B, except that the buried conductive structure 150C is directly connected by an extended portion 160E of the contact structure 160. In addition, components of the present embodiment may be understood with reference to descriptions of the same or similar components of the semiconductor device 100 illustrated in FIGS. 1 to 3A and 3B unless otherwise stated.

Similarly to the previous embodiment, the buried conductive structure 150C may have a structure obtained by using adjacent first and second separation structures SS and adjacent source/drain regions 110 disposed therebetween.

In the present embodiment, the buried conductive structure 150C may be directly connected to the contact structure 160 without passing through a first interconnection structure 180. Specifically, as illustrated in FIG. 7, the contact structure 160 connected to the source/drain region 110 may have a portion 160E extending in one direction (e.g., the Y-direction) and be connected to the buried conductive structure 150C. The extended portion 160E of the contact structure 160 may extend within an intermediate insulating layer 171 to be connected to an upper region 150a of the buried conductive structure 150C.

As described above, the buried conductive structure 150C of the power transmission system may supply power to a device region through various connection structures (e.g., direct connection to the contact structure 160 or the first interconnection structure 180).

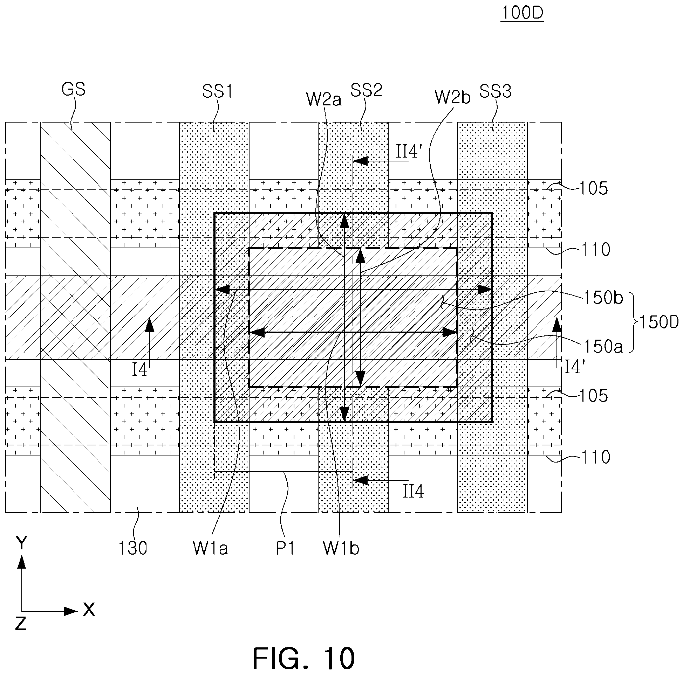

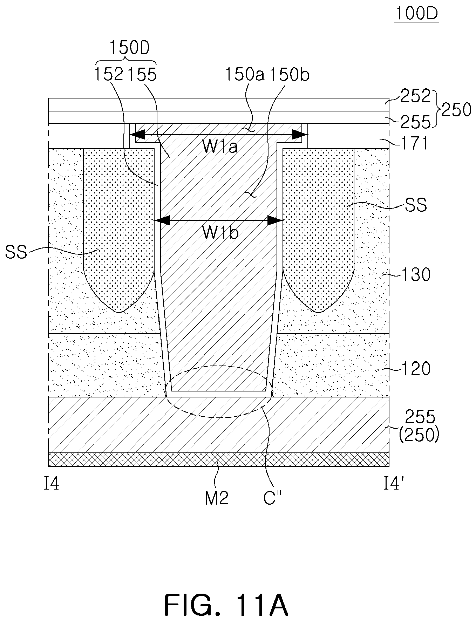

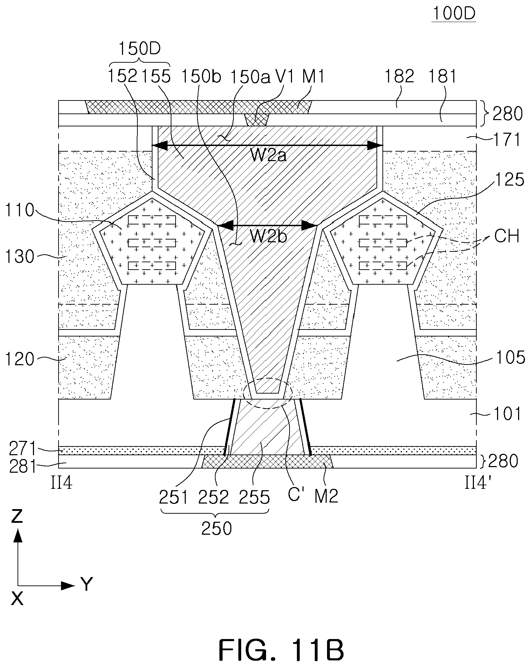

FIG. 10 is a plan view illustrating a semiconductor device according to an example embodiment of the present inventive concept, and FIGS. 11A and 11B are cross-sectional views of the semiconductor device shown in FIG. 10 taken along lines I4-I4' and II4-II4', respectively.

Referring to FIGS. 10, 11A, and 11B, it can be understood that a semiconductor device 100D according to the present embodiment has a structure similar to that of the semiconductor device 100 illustrated in FIGS. 1 to 3A and 3B, except for being defined by separation structures SS1 and SS3 which are spaced from each other in a first direction so as to define a width W1b of a buried conductive structure 150D in the first direction. In addition, components of the present embodiment may be understood with reference to descriptions of the same or similar components of the semiconductor device 100 illustrated in FIGS. 1 to 3A and 3B unless otherwise stated.

The buried conductive structure 150D employed in the present embodiment may extend in a first direction (X-direction). First to third separation structures SS1, SS2, and SS3 may be arranged side by side with each other. The gate structure GS and the first to third separation structures SS1, SS2, and SS3 may be arranged at a constant pitch P1. In the present embodiment, the buried conductive structure 150D may be formed by using the first and third separation structures SS1 and SS3 located on both sides thereof as a mask, as described above. In this process, a region of the second separation structure SS2 overlapping the buried conductive structure 150D may be at least partially removed. The lower region 150b of the buried conductive structure 150D may extend in the first direction (X-direction) to have a wider contact region C" with the power transmission structure 250.

As illustrated in FIG. 11A, a first width W1b of the lower region 150b in the first direction (e.g., the X-direction) may be defined by a distance between the first and third separation structures SS1 and SS3. In the present embodiment, a first width W1b of the lower region 150b may be twice the pitch P1. The first width W1a of the upper region 150a in the first direction (e.g., the X-direction) may be greater than the first width W1b of the lower region 150b.

In addition, similarly to the previous embodiment, as illustrated in FIG. 11B, a second width W2b of the lower region 150b in the second direction (e.g., the Y-direction) may be defined by a distance between adjacent source/drain regions 110, and a second width W2a of the upper region 150a in the second direction (e.g., the Y-direction) may be greater than the second width W2b of the lower region 150b. Unlike the present embodiment, similarly to the extension in the first direction, source and drain regions, which are not adjacent to each other, may be used as a mask for the buried conductive structure 150D, so that the width W2b in the second direction (Y-direction) may also be extended.

As in the present embodiment, according to the configuration of a standard cell, the buried conductive structure 150D may extend in the first direction or the second direction to have a wider contact region with the power transmission structure 250. In particular, when the extension of the buried conductive structure 150D and the extension of the power transmission structure 250 are implemented in the same direction (e.g., X-direction), it may be advantageous to expand the contact region C".

As set forth above, according to the example embodiments described above, difficulty in a photolithography (mask) process and an etching process may be significantly reduced by self-aligning a buried conductive structure (particularly, a lower region) using an existing structure such as a separation structure. In addition, since the buried conductive structure employed in this embodiment may have a relatively large contact area with a power transmission structure in a region between the separation structures, contact resistance may be improved.

Various beneficial advantages and effects of aspects the present inventive concept are not limited to the above description, and will be more easily understood in the process of describing specific embodiments of the present inventive concept.

While example embodiments have been shown and described above, it will be apparent to those skilled in the art that modifications and variations could be made without departing from the aspects of the present inventive concept as defined by the appended claims.

## Claims

1. A semiconductor device (100), comprising:
a substrate (101) having first and second surfaces opposite to each other;
a plurality of fin-type active patterns (105) extending in a first direction (X) on the first surface of the substrate (101);
a gate structure (GS) extending in a second direction (Y), intersecting the first direction (X), and crossing the plurality of fin-type active patterns (105);
a plurality of separation structures (SS) arranged in parallel with the gate structure (GS), and extending in the second direction (Y), respectively;
source/drain regions (110) disposed on the plurality of fin-type active patterns (105) on both sides of the gate structure (GS);
an interlayer insulating layer (130) disposed on the substrate (101), and covering the source/drain regions (110);
a contact structure (160) penetrating the interlayer insulating layer (130), and connected to at least one of the source/drain regions (110);
a buried conductive structure (150) electrically connected to the contact structure (160), and extending in a vertical direction (Z) within the interlayer insulating layer (130) between adjacent separation structures (SS) among the plurality of separation structures (SS), the buried conductive structure (150) having a first width (W1b) in the first direction (X) defined by a distance between the adjacent separation structures (SS); and
a power transmission structure (250) connected to the buried conductive structure (150), and extending from the second surface toward the first surface of the substrate (101).

2. The semiconductor device (100) of claim 1, wherein a width (W2b) of the buried conductive structure (150) in the second direction (Y) is defined by a distance between source/drain regions (110) disposed on adjacent fin-type active patterns (105) among the plurality of fin-type active patterns (105).

3. The semiconductor device (100) of claim 1 or 2, wherein the buried conductive structure (150) comprises a first portion (150b) having the first width (W1b), and a second portion (150a) disposed on the first portion (150b) and having a second width (W1a), greater than the first width (W1b).

4. The semiconductor device (100C) of claim 3, wherein the second portion (150a) of the buried conductive structure (150C) has an extension portion (160E) extending in a direction parallel to the first surface of the substrate (101) and connected to the contact structure (160).

5. The semiconductor device (100) of any preceding claim, wherein the buried conductive structure (150) extends to the first surface of the substrate (101), and the power transmission structure (250) is contact with the buried conductive structure (150) on the first surface of the substrate (101).

6. The semiconductor device (100A) of any one of claims 1 to 4, wherein the buried conductive structure (150A) extends into the substrate (101), and the power transmission structure (250) is contact with the buried conductive structure (150A) in the substrate (101).

7. The semiconductor device (100) of claim 6, wherein the buried conductive structure (150) comprises a first conductive material (155) and a first conductive barrier (152) surrounding a side surface of the first conductive material (155).

8. The semiconductor device (100) of claim 7, wherein the power transmission structure (250) comprises a second conductive material (255) and a second insulating liner (251) surrounding a side surface of the second conductive material (255), and
an upper surface of the power transmission structure (250) has a first region in contact with a bottom surface of the buried conductive structure (150) and a second region around the first region, and the second insulating liner (251) has a portion extending onto the second region of the upper surface of the power transmission structure (250).

9. The semiconductor device (100) of any preceding claim, further comprising:
a first interconnection structure (180) disposed on the interlayer insulating layer (130), and including a first interconnection layer (185) connected to the contact structure (160),
wherein the buried conductive structure (150) is electrically connected to the contact structure (160) through the first interconnection layer (185).

10. The semiconductor device (100) of any preceding claim, further comprising:
a second interconnection structure (280) disposed on the second surface of the substrate (101), and including a second interconnection layer (285) connected to the power transmission structure (250).

11. The semiconductor device (100) of any preceding claim, wherein the power transmission structure (250) comprises a rail structure extending in the first direction (X) between adjacent fin-type active patterns (105) among the plurality of fin-type active patterns (105).

12. The semiconductor device (100) of any one of claims 1 to 10, wherein the power transmission structure (250) comprises a rail structure extending in the second direction (Y) between the adjacent separation structures (SS) among the plurality of separation structures (SS).

13. The semiconductor device (100) of any preceding claim, further comprising a plurality of channel layers (CH) disposed on the plurality of fin-type active patterns (105) and spaced apart from each other in a direction (Z), perpendicular to an upper surface of the substrate (101),
wherein the gate structure (GS) includes a gate electrode (145) surrounding each of the plurality of channel layers (CH) and extending in the second direction (Y), and a gate insulating film (142) disposed between the plurality of channel layers (CH) and the gate electrode (145).

14. The semiconductor device (100) of claim 3, further comprising:
an intermediate insulating layer (171) disposed on the interlayer insulating layer (130) and the plurality of separation structures (SS),
wherein the second portion (150a) of the buried conductive structure (150) is located within the intermediate insulating layer (171).

15. The semiconductor device (100B) of claim 14, further comprising:
a first interconnection structure (180) disposed on the intermediate insulating layer (171), and including a first interconnection layer (185) electrically connected to the contact structure (160), and
a second interconnection structure (280) disposed on the second surface of the substrate (101), and including a second interconnection layer (285) connected to the power transmission structure (250).
